# EUROPEAN PATENT APPLICATION

(11) **EP 3 709 477 A1**
(43) Date of publication of application: **16.09.2020**
(21) Application number: 18876182.9
(22) Date of filing: 21.06.2018
(51) Int. Cl.: H02J 7/14, H05K 1/00

(54) **INTEGRATED ELECTRICAL PRINTED CIRCUIT BOARD SYSTEM**

(30) Priority: 07.11.2017 CN 201721468671 U
(71) Applicant: Nio Nextev Limited, Central, Hong Kong (CN)
(72) Inventor: FAN, Jinyan, Central Hong Kong (CN)
(74) Representative: Vossius & Partner Patentanwälte Rechtsanwälte mbB
(86) International application number: PCT/CN2018/092085
(87) International publication number: WO 2019/091121

(57) **Abstract**

Disclosed is an integrated electrical printed circuit board system, the integrated printed circuit board system comprising a printed circuit board, a high power relay (1), an intermediate relay (2), and a control circuit board (3), wherein the high-power relay (1), the intermediate relay (2), and the control circuit board (3) are connected to each other by means of internal wires in the printed circuit board.

## Description

### Technical Field

The utility model relates to the field of electric vehicles, and in particular to an integrated electrical printed circuit board system, an energy replenishment system for charging an energy storage battery, a charging system for charging an electric vehicle, and an electrical cabinet for a mobile charging vehicle.

### Background Art

With the increase of retention of electric vehicles, the growth rate of charging facilities for electric vehicles cannot meet the charging demand of the electric vehicles. In addition, due to uneven geographical distribution of the charging facilities for the electric vehicles, user experience is poor in remote areas with few or no piles. Mobile charging vehicles can provide a charging service for users anytime and anywhere, which is advantageous for solving the contradictions described above.

An electrical cabinet for the mobile charging vehicle is limited by the volume, and thus relatively complicated electrical functions need to be integrated into the relatively small electrical cabinet. In this case, there are more connection wires in the electrical cabinet while the space is narrow, and the manufacturability and reliability are very poor.

The above information disclosed in the background of the utility model is only intended to facilitate understanding of the overall background of the utility model, and should not be considered as an acknowledgement or any form of suggestion that the information constitutes the prior art already known to those of ordinary skill in the art.

### Summary of the Utility Model

In view of this, the utility model provides a modular design with wires integrated in a printed circuit board (PCB), thereby improving manufacturability, reliability and maintainability. The basic idea of the utility model is to replace, with internal wires in the PCB, connection wires between a high power relay, an intermediate relay and a control circuit board, if possible. When these connection wires therebetween are replaced with wires in the PCB, the connection wires of the entire electrical system will be greatly simplified, which can improve the manufacturability, reliability and maintainability of the electrical system.

According to one aspect of the utility model, an integrated electrical printed circuit board system is provided, the integrated printed circuit board system comprising a printed circuit board, a high power relay, an intermediate relay, and a control circuit board, wherein the high power relay, the intermediate relay, and the control circuit board are connected to each other by means of internal wires in the printed circuit board.

In the integrated electrical printed circuit board system, the high power relay has a power line input and output pin, a relay coil power supply line, an auxiliary contact sampling line, and a voltage sampling line, the voltage sampling line being connected to the power line input and output pin, and the relay coil power supply line, the auxiliary contact sampling line and the voltage sampling line being directed to the printed circuit board and respectively corresponding to a plurality of internal wires in the printed circuit board.

In the integrated electrical printed circuit board system, the intermediate relay is mounted and soldered on the printed circuit board through one or more in-line pins.

In the integrated electrical printed circuit board system, the one or more in-line pins comprise a coil power supply pin, a normally-open contact pin, and a normally-closed contact pin.

In the integrated electrical printed circuit board system, the control circuit board is directly integrated into the printed circuit board.

In the integrated electrical printed circuit board system, the control circuit board is welded on the printed circuit board through a plug pin.

According to another aspect of the utility model, an energy replenishment system for charging an energy storage battery is provided, the energy replenishment system comprising an integrated electrical printed circuit board system as described above.

The energy replenishment system further comprises: an energy replenishment controller; an analog quantity sampling board configured to convert voltage and current, and provide the converted signal to the energy replenishment controller by means of the integrated electrical printed circuit board system; an input and output board configured to be connected to the energy replenishment controller by means of the integrated electrical printed circuit board system; and a debugging and diagnosis board configured to integrate test points for analog signals, input and output signals, and communication network interface signals, which need to be measured, for diagnosis and debugging.

According to still another aspect of the utility model, a charging system for charging an electric vehicle is provided, the charging system comprising an integrated electrical printed circuit board system as described above.

The charging system further comprises: a charging controller; an analog quantity sampling board configured to convert voltage and current, and provide the converted signal to the charging controller by means of the integrated electrical printed circuit board system; an input and output board configured to be connected to the charging controller by means of the integrated electrical printed circuit board system; and a debugging and diagnosis board configured to integrate test points for analog signals, input and output signals, and communication network interface signals, which need to be measured, for diagnosis and debugging.

According to yet another aspect of the utility model, an electrical cabinet for a mobile charging vehicle is provided, the electrical cabinet comprising an energy replenishment system and/or a charging system as described above.

There are a large number of connection wires in existing electrical cabinets. In an onboard environment, connection terminals are prone to become loose and characterized by poor reliability, and are thus difficult to repair after a fault. Compared with the existing solutions, the utility model integrates a large number of wires into the PCB board, thereby reducing the production cost, improving the product reliability, and improving the product maintainability.

Other features and advantages of the method and apparatus in the utility model will become apparent or can be set forth more specifically from the drawings herein and the following particular embodiments for explaining some principles of the utility model together with the drawings.

### Brief Description of the Drawings

FIG. 1 is a schematic structural diagram representing an integrated electrical printed circuit board system according to one embodiment of the utility model;
FIG. 2 is a schematic diagram representing an energy replenishment system according to one embodiment of the utility model; and
FIG. 3 is a schematic diagram representing a charging system according to one embodiment of the utility model.

### Detailed Description of Embodiments

The following description describes specific embodiments of the utility model to teach those skilled in the art how to make and use the best mode of the utility model. In order to teach the principles of the utility model, some conventional aspects have been simplified or omitted. Those skilled in the art should understand that variations derived from these embodiments will fall within the scope of the utility model. Those skilled in the art should understand that the following features can be combined in various ways to form a plurality of variations of the utility model. Thus, the utility model is not limited to the specific embodiments described below, but only defined by the claims and their equivalents.

In the context of the utility model, the terms "PCB", "printed circuit board", "PCB board" or "PCB substrate" have the same meaning, unless otherwise specified.

A power relay is a device which can produce a jump in one or more electrical output circuits when an input quantity (excitation quantity) meets some specified conditions. The power relay may be used in a direct neutral-earthing system to serve as a directional element for zero-sequence current protection. As an example, a high power relay refers to a relay with a rated load current of 10A, 15A, 20A, 25A, 40A or higher for a contact when an open circuit voltage of the contact is a 300 V direct-current voltage.

An intermediate relay is, for example, used in a relay protection and automatic control system to increase the number and capacity of contacts. The intermediate relay is used to transfer an intermediate signal in a control circuit. The structure and principle of the intermediate relay are basically the same as those of an alternating-current contactor, and the main difference from the contactor lies in that: a large current can pass through the main contact of the contactor, while only a small current can pass through the contact of the intermediate relay.

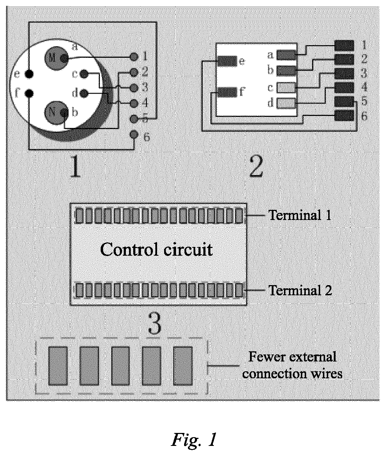

FIG. 1 is a schematic structural diagram representing an integrated electrical printed circuit board system according to one embodiment of the utility model. As shown in FIG. 1, the integrated electrical printed circuit board system comprises a PCB board, a high power relay 1, an intermediate relay 2, and a control circuit 3.

Referring to FIG. 1, in one embodiment, the high power relay 1 has power line input and output pins M and N, relay coil power supply lines e and f, two auxiliary contact sampling lines c and d, and two voltage sampling lines a and b, wherein a is connected to M and b is connected to N on the relay. The power lines are not suitable for PCB integration due to large currents therethrough, while the other six lines can be integrated by means of a PCB due to small currents therethrough.

In order to achieve the integration of the high power relay 1 and the PCB board, it is considered that the high power relay 1 is mounted on the PCB substrate, and the six lines a, b, c, d, e, and f are proximally directed to the PCB to correspond to the internal wires 1, 2, 3, 4, 5, and 6 in the PCB.

With continued reference to FIG. 1, in one embodiment, the intermediate relay 2 has coil power supplies e and f, normally-open contacts a and b, and normally-closed contacts c and d. The intermediate relay can be directly mounted on the PCB due to in-line pins thereof. Since the ON-OFF current of the intermediate relay is relatively small, all wires of the intermediate relay can be integrated by means of the PCB. In this way, there is no need to mount the intermediate relay on a base, so that the cost can be reduced. In addition, under an operating condition of a mobile charging vehicle, there is a higher reliability to directly insert and solder the intermediate relay on the PCB than to insert same on the base.

As shown in FIG. 1, the control circuit board card 3 has a first terminal and a second terminal. The control circuit board card may be directly integrated into the electrical PCB board, or may be welded on the electrical PCB board through a plug pin.

Based on the above three types of integration, external connection wires of the electrical PCB board will be greatly reduced.

In one specific implementation, an integrated electrical function module may be divided into three layers: a main power loop copper bar layer, an electrical PCB integrated board layer, a metal board layer on which the high power relay is mounted. The high power relay needs to be mounted on a metal board due to its large mass. Different from the existing solutions, the above-mentioned implementation makes conventional complicated connection wires into a printed circuit board. For example, a low power intermediate relay is directly soldered on the PCB board, and the wires thereof are also printed inside the PCB. This is convenient for both manufacturing and later maintenance and inspection.

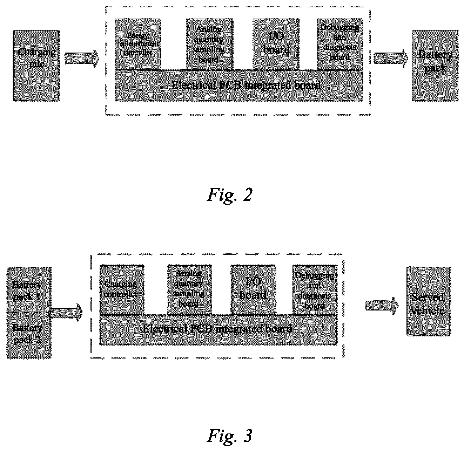

FIG. 2 is a schematic diagram representing an energy replenishment system according to one embodiment of the utility model. The energy replenishment system replenishes a battery pack with energy by means of power provided by a charging pile. In one embodiment, as shown by the dashed box in FIG. 2, an energy replenishment controller, an analog quantity sampling board, an I/O board, and a debugging and diagnosis board are integrated on one PCB board, which has external interfaces to a direct-current charging pile and to a battery pack, and a debugging interface and a diagnostic interface.

In FIG. 2, the energy replenishment controller is a board card with an MCU microcontroller. The analog quantity sampling board functions to convert a large voltage and a large current into small signals and then pass same to the MCU of the energy replenishment controller through the electrical PCB substrate. The I/O board is a board for a control loop of the relay and for loopback signals by the auxiliary contact of the relay, and signals of the I/O board are also connected to the energy replenishment controller by means of the electrical PCB integrated board. The debugging and diagnosis board integrates test points for analog signals, I/O signals, and communication network interface signals, which need to be measured, through which debugging and diagnosis can be performed conveniently. This board card is used in processes such as a research and development stage, product manufacturing and testing, product quality inspection, operation and maintenance, and fault diagnosis, such that the efficiency in these stages can be improved.

FIG. 3 is a schematic diagram representing a charging system according to one embodiment of the utility model. The charging system charges served vehicles with power provided by one or more battery packs. In one embodiment, as shown by the dashed box in FIG. 3, a charging controller, an analog quantity sampling board, an I/O board, and a debugging and diagnostic board are integrated on one PCB board, which has external interfaces to a battery pack and to a served vehicle, and a debugging interface and a diagnostic interface.

In FIG. 3, the charging controller is a board card with an MCU microcontroller. The analog quantity sampling board functions to convert a large voltage and a large current into small signals and then pass same to the MCU of the charging controller through the electrical PCB substrate. The I/O board is a board for a control loop of the relay and for loopback signals by the auxiliary contact of the relay, and signals of the I/O board are also connected to the charging controller by means of the electrical PCB integrated board. The debugging and diagnosis board integrates test points for analog signals, I/O signals, and communication network interface signals, which need to be measured, through which debugging and diagnosis can be performed conveniently. This board card is used in processes such as a research and development stage, product manufacturing and testing, product quality inspection, operation and maintenance, and fault diagnosis, such that the efficiency in these stages can be improved.

In one specific implementation, the energy replenishment system and/or the charging system described above may be applied to an electrical cabinet for a mobile charging vehicle.

In conclusion, the utility model integrates a large number of wires into the PCB board, thereby reducing the production cost, improving the product reliability, and improving the product maintainability.

The above examples mainly illustrate the integrated electrical printed circuit board system, the energy replenishment system for charging an energy storage battery, the charging system for charging an electric vehicle, and the electrical cabinet for a mobile charging vehicle in the utility model. Although only some specific embodiments of the utility model are described, it will be appreciated by those skilled in the art that the utility model may be embodied in many other forms without departing from the essence and scope thereof. Therefore, the presented examples and embodiments are deemed as exemplary rather than restrictive, and the utility model may encompass various modifications and substitutions without departing from the spirit and scope of the utility model that are defined by the appended claims.

## Claims

1. An integrated electrical printed circuit board system, **characterized by** comprising a printed circuit board, a high power relay, an intermediate relay, and a control circuit board, wherein the high power relay, the intermediate relay, and the control circuit board are connected to each other by means of internal wires in the printed circuit board.

2. The integrated electrical printed circuit board system of claim 1, wherein the high power relay has a power line input and output pin, a relay coil power supply line, an auxiliary contact sampling line, and a voltage sampling line, the voltage sampling line being connected to the power line input and output pin, and the relay coil power supply line, the auxiliary contact sampling line and the voltage sampling line being directed to the printed circuit board and respectively corresponding to a plurality of internal wires in the printed circuit board.

3. The integrated electrical printed circuit board system of claim 1, wherein the intermediate relay is mounted and soldered on the printed circuit board through one or more in-line pins.

4. The integrated electrical printed circuit board system of claim 3, wherein the one or more in-line pins comprise a coil power supply pin, a normally-open contact pin, and a normally-closed contact pin.

5. The integrated electrical printed circuit board system of claim 1, wherein the control circuit board is directly integrated into the printed circuit board.

6. The integrated electrical printed circuit board system of claim 1, wherein the control circuit board is welded on the printed circuit board through a plug pin.

7. An energy replenishment system for charging an energy storage battery, **characterized by** comprising an integrated electrical printed circuit board system of any of claims 1 to 6.

8. The energy replenishment system of claim 7, **characterized by** further comprising:
an energy replenishment controller;
an analog quantity sampling board configured to convert voltage and current, and provide the converted signal to the energy replenishment controller by means of the integrated electrical printed circuit board system;
an input and output board configured to be connected to the energy replenishment controller by means of the integrated electrical printed circuit board system; and
a debugging and diagnosis board configured to integrate test points for analog signals, input and output signals, and communication network interface signals, which need to be measured, for diagnosis and debugging.

9. A charging system for charging an electric vehicle, **characterized by** comprising an integrated electrical printed circuit board system of any of claims 1 to 6.

10. The charging system of claim 9, **characterized by** further comprising:
a charging controller;
an analog quantity sampling board configured to convert voltage and current, and provide the converted signal to the charging controller by means of the integrated electrical printed circuit board system;
an input and output board configured to be connected to the charging controller by means of the integrated electrical printed circuit board system; and
a debugging and diagnosis board configured to integrate test points for analog signals, input and output signals, and communication network interface signals, which need to be measured, for diagnosis and debugging.

11. An electrical cabinet for a mobile charging vehicle, **characterized by** comprising an energy replenishment system of claim 7 or 8 and/or a charging system of claim 9 or 10.
